Europäisches Patentamt

European Patent Office

Office européen des brevets

(11) Veröffentlichungsnummer: **0 233 675 B1**

# (12) EUROPÄISCHE PATENTSCHRIFT

(45) Veröffentlichungstag der Patentschrift: **11.05.94**

(51) Int. Cl.⁵: $G01N\ 24/08$

(21) Anmeldenummer: **87200261.3**

(22) Anmeldetag: **18.02.87**

(54) **Verfahren zur Ermittlung der spektralen Verteilung der Kernmagnetisierung in einem begrenzten Volumenbereich und Anordnung zur Durchführung des Verfahrens.**

(30) Priorität: **21.02.86 DE 3605547**
**17.05.86 DE 3616749**

(43) Veröffentlichungstag der Anmeldung:
**26.08.87 Patentblatt 87/35**

(45) Bekanntmachung des Hinweises auf die
Patenterteilung:
**11.05.94 Patentblatt 94/19**

(84) Benannte Vertragsstaaten:
**BE DE FR GB IT NL SE**

(56) Entgegenhaltungen:

**JOURNAL OF MAGNETIC RESONANCE, Band
64, 1985, Seiten 479-486, Academic Press,
Inc., US; K.-D. MERBOLDT et al.: "Self-diffusion NMR imaging using stimulated echoes"**

**JOURNAL OF MAGNETIC RESONANCE, Band
64, 1985, Seiten 81-93, Academic Press, Inc.,
US; J. FRAHM et al.: "Stimulated echo imaging"**

(73) Patentinhaber: **Philips Patentverwaltung
GmbH
Wendenstrasse 35c
D-20097 Hamburg(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**BE FR GB IT NL SE**

(72) Erfinder: **McKinnon, Graeme Colin, Dr.
Höschgasse 62
CH-8008 Zürich(CH)**

(74) Vertreter: **Hartmann, Heinrich, Dipl.-Ing. et al
Philips Patentverwaltung GmbH,
Wendenstrasse 35c
D-20097 Hamburg (DE)**

JOURNAL OF MAGNETIC RESONANCE, Band 65, 1985, Seiten 130-135, Academic Press, Inc., US; J. FRAHM et al.: "Rapid NMR imaging using stimulated echoes"

JOURNAL OF MAGNETIC RESONANCE, Band 56, 1984, Seiten 350-354, Academic Press, Inc., US; W.P. AUE et al.: "Volume-selective excitation. A novel approach to topical NMR"

**Beschreibung**

Die Erfindung betrifft ein Verfahren zur Ermittlung der spektralen Verteilung der Kernmagnetisierung in einem begrenzten Volumenbereich, wobei in Anwesenheit eines stationären homogenen Magnetfeldes drei Hochfrequenzimpulse jeweils in Verbindung mit einem magnetischen Gradientenfeld auf den Untersuchungsbereich einwirken, wobei die Richtung des Gradienten des magnetischen Gradientenfeldes von Impuls zu Impuls um 90° geändert wird und das im Untersuchungsbereich erzeugte stimulierte Echosignal abgetastet und verarbeitet wird sowie eine Anordnung zu Durchführung des Verfahrens.

Ein solches Verfahren ist im wesentlichen aus der Zeitschrift J.Magn.Reson. 64 (1985), Seiten 479 bis 486, insb. Seite 482, bekannt, allerdings nicht in Verbindung mit der Bestimmung der spektralen Verteilung der Kernmagnetisierung, sondern in Verbindung mit der Bestimmung von Diffusionskoeffizienten in dem Volumenbereich. Durch die drei jeweils in Verbindung mit einem magnetischen Gradientenfeld auf den Untersuchungsbereich einwirkenden Hochfrequenzimpulse wird die Kernmagnetisierung in drei aufeinander senkrecht stehenden Schichten angeregt. Dabei entsteht in dem begrenzten Volumenelement, in dem sich die drei Schichten schneiden, u.a. ein stimuliertes Echosignal. Ein stimuliertes Echosignal tritt bekanntlich bei drei aufeinanderfolgenden Hochfrequenzimpulsen auf, wobei der Abstand der zeitlichen Mitte dieses Signals von der Mitte des dritten Hochfrequenzimpulses dem Abstand der Mitten der beiden ersten Hochfrequenzimpulse entspricht.

Eine Variante des bekannten Verfahrens zur Bestimmung von Diffusionskoeffizienten ist in der Zeitschrift J.Magn.Reson. 65, 130 - 135 (1985) beschrieben. Dabei ist der dritte Hochfrequenzimpuls so gestaltet, daß die Kernmagnetisierung durch ihn nur um einen kleinen Winkel gekippt wird. Dies wird dazu ausgenutzt, das Zeitintervall mit dem dritten Hochfrequenzimpuls, dem noch ein Phasenkodierungsgradient sowie ein Lesegradient folgen n mal zu wiederholen. In dieser Veröffentlichung ist darauf hingewiesen, daß sich Störungen der stimulierten Echosignale durch unerwünschte Spinechos ergeben können, die im Zusammenwirken mit dem FID oder den stimulierten Echosignalen aus vorangegangenen Intervallen entstehen können.

Weiterhin ist aus der Zeitschrift J.Magn.Reson. 56 (1984), Seiten 350 bis 354 bereits ein Verfahren zur selektiven Volumenanregung bekannt, bei dem in drei aufeinanderfolgenden Zeitabschnitten drei magnetische Gradientenfelder mit senkrecht aufeinanderstehenden Gradienten eingeschaltet werden. Während jedes dieser drei Zeitabschnitte werden zwei schmalbandige 45° Hochfrequenzimpulse und ein breitbandiges 90° Hochfrequenzimpuls erzeugt. Dadurch wird in drei zueinander senkrechten Schichten, deren Dicke durch die Bandbreite der 45° Impulse bestimmt ist, die Kernmagnetisierung in der z-Richtung gehalten, während sie außerhalb der Schichten in die xy-Ebene gekippt wird, wo sie unter dem Einfluß eines im Anschluß an die drei Zeitabschnitte angelegten magnetischen Gradientenfeldes schnell dephasiert. Wenn daher anschließend ein oder mehrere Hochfrequenzimpulse auf den Untersuchungsbereich einwirken, liefert nur das im Schnittpunkt der drei Schichten liegende Volumenelement einen Beitrag zu dem dadurch erzeugten Kernspin-Resonanzsignal.

Ausgehend von einem Verfahren der eingangs genannten Art wird diese Aufgabe durch die im kennzeichnenden Teil des Hauptanspruchs angegebenen Maßnahmen gelöst.

Bei der Erfindung wird durch die drei Hochfrequenzimpulse in Verbindung mit den dabei wirksamen Gradientenfeldern die Kernmagnetisierung in drei zueinander senkrechten Schichten angeregt. Nur der Bereich, in dem sich diese drei Schichten schneiden, liefert ein stimuliertes Echosignal. Das Spektrum dieses Echosignals, das durch eine Fourier-Transformation erhalten wird, ergibt die spektrale Verteilung der Kernmagnetisierung in dem Schnittbereich der drei Schichten.

Neben den stimulierten Echosignalen werden im Schnittbereich der drei Schichten - zum Teil jedoch auch in den Schichten außerhab dieses Schnittbereichs - weitere Kernspin-Resonanzsignale erzeugt. So verursacht jeder der drei Hochfrequenzimpulse beispielsweise einen freien Induktionszerfall, der mit einem sogenannten FID-Signal verknüpft ist, das unmittelbar im Anschluß an den Hochfrequenzimpuls auftritt und von der Kernmagnetisierung in der gesamten jeweils angeregten Schicht abhängt. Außerdem treten noch verschiedene Spin-Echo-Signale auf, von denen mindestens ein Teil von der Kernmagnetisierung in den Schnittbereichen von zwei der drei Schichten - also auch außerhalb des anzuregenden Volumenelementes - abhängen. Diese Signale sind auch beim Auftreten des stimulierten Echosignals mehr oder weniger wirksam und verfälschen das Meßergebnis, weil sie größtenteils von der Kernmagnetisierung außerhalb des durch die drei Schichten bestimmten Volumenbereichs abhängen. Es ist daher wesentlich, daß alle diese Signale - bis auf das stimulierte Echosignal - unterdrückt werden.

Zu diesem Zweck wird in jedem der drei Intervalle zwischen den drei Hochfrequenzimpulsen und zwischen dem dritten Hochfrequenzimpuls und dem Auftreten des stimulierten Echosignals ein magnetisches Gradientenfeld ein- und ausgeschaltet. Dies hat zur Folge, daß die Phase der Kernmagnetisierung in Richtung des Gradienten des magnetischen Gradientenfeldes vom Ort abhängt. Die Dauer, die Größe und die Richtung des Gradienten dieser magnetischen Gradientenfelder sind nun so gewählt, daß die Kernmagnetisierung aufgrund der erzeugten Dephasierung keinen Beitrag zu den verschiedenen Kernspin-Resonanzsignalen - bis auf das stimulierte Echosignal - liefert.

Dabei wird die Tatsache ausgenutzt, daß ein magnetisches Gradientenfeld im Intervall zwischen dem zweiten und dem dritten Hochfrequenzimpuls keinen Einfluß auf das stimulierte Echosignal hat und daß ein magnetisches Gradientenfeld nach dem ersten Hochfrequenzimpuls den entgagengesetzten Einfluß auf ein solches Signal hat wie ein magnetisches Gradientenfeld (mit gleicher Richtung, Dauer und Amplitude) nach dem dritten Hochfrequenzimpuls. Wenn daher das zeitliche Integral über das magnetische Gradientenfeld nach dem ersten Hochfrequenzimpuls gleich dem entsprechenden Integral nach dem dritten Hochfrequenzimpuls ist, dann hat dies keinen Einfluß auf das stimulierte Echosignal, unterdrückt jedoch schon die drei FID Signale und einen Teil der Spin-Echo-Signale. Durch geeignete Wahl von Richtung, Dauer und Stärke des im Intervall nach dem zweiten Hochfrequenzimpuls wirksamen magnetischen Gradientenfeldes können auch die restlichen Spin-Echo-Signale unterdrückt werden. Dies ist dann der Fall, wenn der Gradient dieses Gradientenfeldes in einer anderen Richtung verläuft als der Gradient der in den Intervallen nach dem ersten und nach dem dritten Hochfrequenzimpuls wirksamen Gradientenfelder und/oder wenn die Bedingung $I1 = I2/n$ erfüllt ist.

Die drei Hochfrequenzimpulse müssen den gleichen Flipwinkel aufweisen; vorzugsweise sind alle drei Hochfrequenzimpulse sogenannte 90°-Impulse.

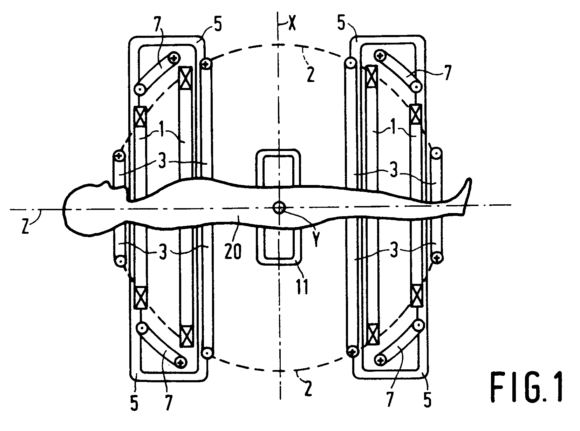

Es ist bekannt, daß durch das Einwirken eines magnetischen Gradientenfeldes während eines Hochfrequenzimpulses die Kernmagnetisierung innerhalb und senkrecht zur angeregten Schicht dephasiert ist. Diese Dephasierung läßt sich in bekannter Weise (vgl. z.B. Phys. Med. Biol., Vol. 25, 1980, Seiten 751 bis 756, insb. Fig. 1) dadurch beseitigen, daß die Polarität des magnetischen Gradientenfeldes nach dem Hochfrequenzimpuls umgekehrt wird, wobei das zeitliche Integral über das magnetische Gradientenfeld von der Mitte des Hochfrequenzimpulses bis zum Abschalten dieses Gradientenfeldes null sein muß.

Es hat sich jedoch gezeigt, daß, wenn die drei zueinander senkrechten Schichten bei dem erfindungsgemäßen Verfahren auf diese Weise angeregt werden, die Dephasierung nicht völlig beseitigt werden kann, so daß das erzeugte stimulierte Echosignal relativ schwach ist bzw. ein relativ schlechtes Signal-Rauschverhältnis aufweist. Die geschilderte Dephasierung bzw. die daraus resultierende Verschlechterung des Signal/Rauschverhältnisses läßt sich nach einer Weiterbildung der Erfindung zumindest näherungsweise dadurch vermeiden, daß die Polarität des während des ersten bzw. des dritten Hochfrequenzimpulses wirksamen magnetischen Gradientenfeldes nach dem ersten bzw. dem dritten Hochfrequenzimpuls umgeschaltet wird, daß vor dem zweiten Hochfrequenzimpuls das magnetische Gradientenfeld mit einer zur Polarität dieses Feldes während des zweiten Impulses entgegengesetzten Polarität eingeschaltet wird, und daß der zeitliche Verlauf jedes der während eines Hochfrequenzimpulses wirksamen Gradientenfelder so gewählt ist, daß das zeitlich Integral von der Mitte des ersten bzw. des dritten Hochfrequenzimpulses bis zum Abschalten des jeweiligen Gradientenfeldes bzw. vom Einschalten des Gradientenfeldes bis zur Mitte des zweiten Hochfrequenzimpulses Null ist.

Diese Ausgestaltung der Erfindung basiert auf der Erkenntnis, daß der erste und der dritte (90°-) Hochfrequenzimpuls den Vektor der Kernmagnetisierung von der longitudinalen (d.h. der z-) Richtung in die transversale Richtung (d.h. in die xy-Ebene) kippen, während der zweite Hochfrequenzimpuls spiegelbildlich dazu die Kernmagnetisierung von der transversalen in die longitudinale Richtung kippt. Deshalb muß der zweite Impuls und das ihn begleitende magnetische Gradientenfeld in zeitlicher Hinsicht das Spiegelbild des ersten bzw. des dritten Hochfrequenzimpulses mit dem jeweils begleitenden magnetischen Gradientenfeld sein. Dies wird durch die Weiterbildung der Erfindung sichergestellt.

Eine Anordnung zur Durchführung des erfindungsgemäßen Verfahrens ist versehen mit einem Magneten zur Erzeugung eines homogenen stationären Magnetfeldes, einer Hochfrequenz-Spulenanordnung zur Erzeugung eines hochfrequenten, zum stationären Magnetfeld senkrechten Magnetfeldes, einem Hochfrequenzgenerator zu Speisung der Hochfrequenz-Spulenanordnung, einer Gradienten-Spulenanordnung zur Erzeugung von in Richtung des stationären Magnetfeldes verlaufenden Magnetfeldern mit in verschiedenen Richtungen verlaufenden Gradienten, mit Generatoren zur Speisung der Gradientenspulen, einer Steuereinheit zur Steuerung des Hochfrequenz-Generators und der Generatoren und mit einer Recheneinheit zur Verarbeitung des stimulierten Echosignals, und ist dadurch gekennzeichnet, daß die Steuereinheit so programmiert ist, daß in den Intervallen zwischen den drei Hochfrequenzimpulsen und zwischen dem dritten Hochfrequenzimpuls und dem Auftreten des stimulierten Echosignals magnetische Gradientenfelder eingeschaltet werden, wobei der Gradient der im Intervall nach dem ersten Hochfrequenzimpuls und nach dem dritten Hochfrequenzimpuls wirksamen Gradientenfelder in der gleichen Richtung verläuft und der Beziehung I1 = I3 erfüllt ist, wobei I1 bzw. I3 das zeitliche Integral über den Gradienten im Intervall nach dem ersten bzw. dem dritten Hochfrequenzimpuls ist und wobei der Gradient des im Intervall nach dem zweiten Hochfrequenzimpuls erzeugten Gradientenfeldes senkrecht zu den Gradienten der nach dem ersten bzw. dem dritten Intervall erzeugten Gradientenfelder verläuft und/oder die Beziehung I1 = I2/n erfüllt ist, wobei I2 das zeitliche Integral über das magnetische Gradientenfeld nach dem zweiten Hochfrequenzimpuls ist und n eine positive oder negative Zahl ist, deren Betrag von 1 und 2 abweicht, und daß die Recheneinheit zum Durchführen einer Fourier-Transformation ausgebildet ist.

Die Erfindung wird nachstehend anhand der Zeichnung näher erläutert. Es zeigen:

Fig. 1   ein Kernspin-Untersuchungsgerät zur Durchführung erfindungsgemäßen Verfahrens,

Fig. 2   ein Blockschaltbild eines solchen Gerätes, und

Fig. 3   den zeitlichen Verlauf verschiedener Signale bei dem erfindungsgemäßen Verfahren.

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensysten bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. - Im Anschluß an drei Hochfrequenzimpulse dient die Hochfrequenzspule 11 zum Empfangen des im Untersuchungsbereich erzeugten stimulierten Echosignals. Statt dessen kann aber auch eine gesonderte Hochfrequenz-Empfangsspule verwendet werden.

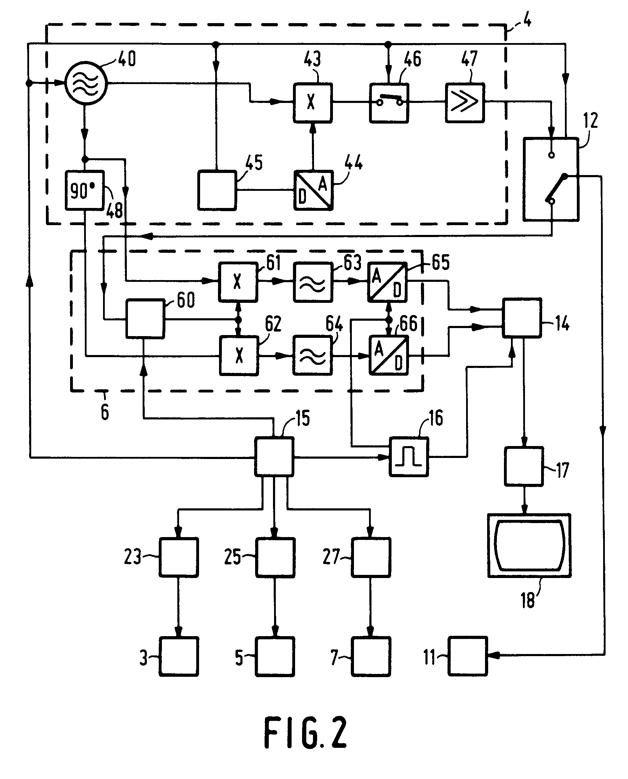

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen 1 erzeugten Feldstärke aufweist. Die Larmorfrequenz f berechnet sich bekanntlich nach der Beziehung f = cB, wobei B die magnetische Induktion in demstationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß in ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadrator-Demodulator bildenden Schaltung 61...64 in digitale Datenworte um, die einem Speicher 14 zugeführt werden. Die Analog-Digital-Wandler 65 und 66 sowie der Speicher 14 enthalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner 17 zugeführt, der daraus durch eine diskrete Fourier-Transformation die Spektralverteilung der Kernmagnetisierung ermittelt und die ermittelte Verteilung an einer geeigneten Wiedergabeeinheit, z.B. einem Monitor 18, ausgibt.

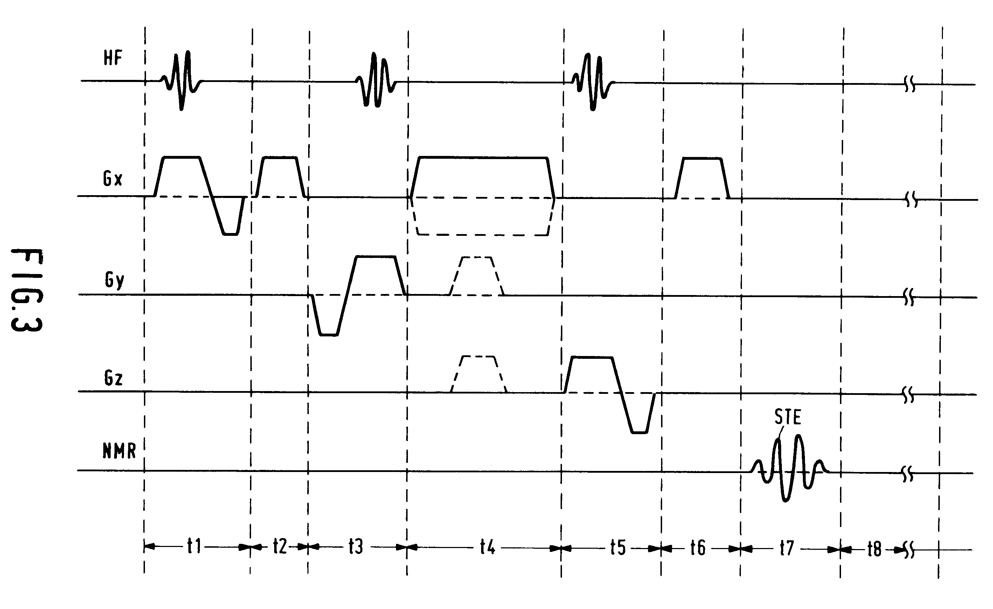

In Fig. 3 ist der zeitliche Verlauf von verschiedenen mit der Schaltung nach Fig. 2 empfangenen oder erzeugten Signalen für das erfindungsgemäße Verfahren dargestellt. Die erste Zeile zeigt den zeitlichen Verlauf des Ausgangssignals des Hochfrequenzerzeugers 4. Die zweite, dritte bzw. vierte Zeile zeigen den zeitlichen Verlauf des magnetischen Gradientenfeldes Gx, Gy bzw. Gz, das mittels der Spulenanordnungen 7, 5 bzw. 3 und der Generatoren 27, 25 bzw. 23 erzeugt wird. In der fünften Zeile ist der zeitliche Verlauf des Signals an einem der Tiefpässe 63 bzw. 64 angedeutet.

Das erfindungsgemäße Verfahren umfaßt acht aneinander anschließende Zeitintervalle t1...t8. Während der Zeitintervalle t1, t3 und t5 wird je ein Hochfrequenzimpuls, vorzugsweise ein 90°-Hochfrequenzimpuls, erzeugt, d.h. der Schalter 46 ist dann geschlossen, und der Umschalter 12 befindet sich in der in Fig. 2 nicht dargestellten Schaltstellung. Die Mittenfrequenz jedes Hochfrequenzimpulses ist durch die Frequenz des Oszillators 40 bestimmt. Diese muß der Larmorfrequenz der anzuregenden Kernspins bei der vorgegebenen Feldstärke des stationären homogenen Magnetfeldes entsprechen, das durch die Spulen 1 erzeugt wird. Die Bandbreite der Hochfrequenzimpulse und ihr zeitlicher Verlauf hängen von dem zeitlichen Verlauf des in dem Speicher 45 gespeicherten Hüllkurvensignals ab.

Während des ersten Zeitintervalls t1 wird das magnetische Gradientenfeld Gx eingeschaltet, und zwar so, daß es während des gesamten Hochfrequenzimpulses konstant ist. Dadurch wird erreicht, daß durch den ersten Hochfrequenzimpuls die Kernmagnetisierung in einer zur x-Achse senkrechten Schicht angeregt wird, deren Dicke die Bandbreite des Hochfrequenzimpulses und die Größe des Gradienten des magnetischen Gradientenfeldes vorgegeben ist. Nach dem Hochfrequenzimpuls wird die Polarität des magnetischen Gradientenfeldes umgeschaltet und das magnetische Gradientenfeld Gx noch im Zeitintervall t1 abgeschaltet. Der zeitliche Verlauf des magnetischen Gradientenfeldes ist dabei so gewählt, daß das zeitliche Integral über dieses Gradientenfeld von der Mitte des Hochfrequenzimpulses bis zum Abschalten Null ist. Dadurch wird erreicht, daß die Phasenlage der Kernmagnetisierung in der angeregten Schicht unabhängig von der x-Koordinate ist.

Auf analoge Weise wird die Kernmagnetisierung während des fünften Intervalls t5 durch Anlegen eines magnetischen Gradientenfeldes Gz in einer zur z-Richtung senkrechten Schicht angeregt. Wenn das magnetische Gradientenfeld Gy im dritten Intervall t3 den gleichen zeitlichen Verlauf hätte, wie die Gradientenfelder Gx bzw. Gz im ersten Intervall t1 bzw. im fünften Intervall t5, dann wäre die Kernmagnetisierung in dem Schnittbereich der durch die drei Hochfrequenzimpulse angeregten Schichten zum Teil dephasiert. Diese Dephasierung wird dadurch vermieden, daß - wie aus zweiten Zeile von Fig. 3 ersichtlich - vor dem zweiten Hochfrequenzimpuls im Zeitintervall t3 das magnetische Gradientenfeld Gy mit in y-Richtung verlaufendem Gradienten eingeschaltet wird, wodurch die Kernmagnetisierung in der durch den ersten Hochfrequenzimpuls angeregten, zur x-Achse senkrechten Schicht in y-Richtung dephasiert wird. Dadurch, daß die Polarität dieses Gradientenfeldes umgeschaltet wird, so daß dieses Feld während des zweiten Hochfrequenzimpulses die entgegengesetzte Polarität hat wie unmittelbar zuvor, und dadurch, daß der zeitliche Verlauf des magnetischen Gradientenfeldes so gewählt ist, daß das zeitliche Integral über dieses Feld von dem Einschalten bis zur Mitte des zweiten Hochfrequenzimpulses Null ist, wird diese Dephasierung jedoch wieder beseitigt. Dadurch wird das Signal/Rauschverhältnis des im siebten Zeitintervall t7 auftretenden stimulierten Echosignals, das allein durch die Kernmagnetisierung im Schnittbereich der drei Schichten bestimmt ist, verbessert.

Im siebten Zeitintervall t7 tritt ein stimuliertes Echosignal auf, das allein durch die Kernmagnetisierung im Schnittbereich der drei Schichten bestimmt ist. Es wird durch die Spule 11 in ein elektrisches Signal umgesetzt, über den Umschalter 12 dem Empfänger 6 zugeführt und dort in eine Folge von digitalen Abtastwerten umgesetzt in die dem Speicher 14 gespeichert und anschließend im Rechner 17 einer Fourier-Transformation unterzogen. Nur während des Zeitintervalls t7 erzeugt der Taktgenerator 16 Taktimpulse, so daß nur die in diesem Zeitintervall auftretenden Abtastwerte gespeichert werden können. Der Abstand der Mitte des stimulierten Echosignals von der Mitte des dritten Hochfrequenzimpulses entspricht dem zeitlichen Abstand der Mitten der beiden ersten Hochfrequenzimpulse.

In den Zeitintervallen t2, t4 bzw. t6 nach dem ersten, dem zweiten bzw. dem dritten Hochfrequenzimpuls, d.h. nach dem Abschalten des zu dem betreffenden Hochfrequenzimpuls gehörenden magnetischen Gradientenfeldes, werden zur Unterdrückung aller anderen Arten von Kernspin-Resonanzsignalen magnetische Gradientenfelder erzeugt. In dem Zeitintervall t2 wird ein magnetisches Gradientenfeld erzeugt, dessen zeitliches Integral von Null verschieden ist. Der Gradient dieses Feldes kann in einer beliebigen Richtung verlaufen. Im Ausführungsbeispiel wird davon ausgegangen, daß der Gradient in x-Richtung verläuft. In dem Zeitintervall t6 nach dem dritten Hochfrequenzimpuls wird ein magnetisches Gradientenfeld erzeugt, dessen Gradient in der gleichen Richtung verläuft wie der Gradient des im Zeitintervall t2 wirksamen magnetischen Gradientenfeldes und dessen zeitliches Integral dem zeitlichen Integral über das während des Zeitintervalls t2 wirksame magnetische Gradientenfeld entspricht. Während des Zeitintervalls t4 zwischen dem zweiten und dem dritten Hochfrequenzimpuls wird ein magnetisches Gradientenfeld angelegt, dessen Gradient die gleiche Richtung und Polarität hat wie der Gradient der während der Zeitintervalle t2 bzw. t6 wirksamen magnetischen Gradientenfelder. Jedoch ist das zeitliche Integral über dieses magnetische Gradientenfeld dreimal so groß wie das entsprechende Integral für die Zeitintervalle t2 bzw. t6.

Grundsätzlich bewirkt jedes der drei während der Zeitintervalle t2, t4 bzw. t6 wirksamen magnetischen Gradientenfelder eine Dephasierung bzw. Phasenverschiebung, die dem zeitlichen Integral über das magnetische Gradientenfeld während des betreffenden Zeitintervalls proportional ist. Außerdem ist die Phasenverschiebung noch dem Abstand x vom Nullpunkt des kartesischen Koordinatensystems proportional. Die Dephasierung, die durch die während der Zeitintervalle t2, t4 bzw. t6 wirksamen magnetischen Gradientenfelder hervorgerufen wird, wird im folgenden mit I1, I2 bzw. I3 bezeichnet. Voraussetzungsgemäß entsprechen sich I1 und I3, während I2 dreimal so groß ist wie I1 oder I3.

Die folgende Aufstellung zeigt, wie sich die verschiedenen Dephasierungen auf die unterschiedlichen Arten der Kernspin-Resonanzsignal auswirken. Dabei steht STE für stimuliertes Echosignal, SE für Spin-Echo-Signal und FID für FID-Signal. In Klammern ist für jedes Signal angegeben, durch welche Hochfrequenzimpulse es bedingt ist.

```
STE (1, 2, 3): I1 - I3

SE  (1, 2)   : I1 - I2 - I3

SE  (1, 3)   : I1 + I2 - I3

SE  (2, 3)   : I2 - I3

SE  (1, 2, 3): I1 - I2 + I3

FID (1)      : I1 + I2 + I3

FID (2)      : I2 + I3

FID (3)      : I3
```

Man erkennt, daß die Phasenverschiebung für das stimulierte Echosignal Null ist, weil für dieses Signal die Dephasierung durch die magnetischen Gradientenfelder nach dem ersten und dem dritten Hochfrequenzimpuls aneinander entgegengesetzt gleich sind. Man erkennt weiter, daß für alle anderen Kernspin-Resonanzsignale bei dem angegebenen Wert von I3 die Dephasierung von Null verschieden ist. Diese Signale werden daher unterdrück, wenn die Dephasierung genügend groß ist, d.h. wenn die Bedingung $dx|1 \geq 2\pi/c$ erfüllt ist. Dabei ist dx die Dicke der zur x-Achse senkrechten Schicht, d.h. der Schicht, zu der der Gradient während des zweiten Zeitintervalls t2 bzw. während des sechsten Zeitintervalls t6 senkrecht verläuft, und c das gyromagnetische Verhältnis.

Die Aufstellung zeigt weiter, daß sich genauso gute Resultate ergeben, wenn die Bedingung I1 bzw. I3 gleich -3I2 erfüllt ist. Wie gestrichelt angedeutet, kann der Gradient in x-Richtung während des Zeitintervalls t4 also auch eine negative Polarität haben. - Andererseits ist erkennbar, daß auch die Signale SE (2, 3) oder FID (2) nicht dephasiert würden, wenn die Beziehung I2 = I3 bzw. I2 = -I3 erfüllt wäre; ebenso sieht man, daß die Signale SE (1, 2) bzw. SE (1, 2, 3) nicht unterdrückt würden, wenn I2 gleich 2I3 bzw. I2 gleich -2I3 gelten würde. Da I2 auch nicht Null sein darf, damit das Signal SE (1, 3) unterdrückt wird, sollte die Bedingung erfüllt sein, daß I2 dem Betrage nach wenigstens dreimal so groß ist wie I2 bzw. I3 - falls der Gradient im Zeitintervall t4 in der gleichen oder der entgegengesetzten Richtung verläuft, wie die Gradienten im Zeitintervall t2 bzw. t6.

Es ist aber auch möglich, die übrigen Kernspin-Resonanzsignale zu unterdrücken, wenn im Intervall t4 ein magnetisches Gradientenfeld angelegt wird, dessen Gradient nicht in der gleichen bzw. entgegengesetzten Richtung verläuft, wie der Gradient während der Zeitintervalle t2 bzw. t6. Wenn der Gradient des im Zeitintervall t4 wirksamen magnetischen Gradientenfeldes beispielsweise in y- oder in z-Richtung verläuft, können alle Signale unterdrückt werden, die von I2 abhängig sind. Das durch den dritten Hochfrequenzimpuls erzeugte Signal FID (3), das ebenso wie das stimulierte Echosignal STE von dem magnetischen Gradientenfeld zwischen dem zweiten und dem dritten Hochfrequenzimpuls unabhängig ist, wird durch das im Zeitintervall t6 wirksame magnetische Gradientenfeld unterdrückt.

In diesen Fällen kann also im Zeitintervall t4 der Generator 27 für die Gradientenspulen 7 abgeschaltet bleiben und es kann statt dessen mittels der Generatoren 23 oder 25 ein magnetisches Gradientenfeld Gy oder Gz erzeugt werden, dessen zeitlicher Verlauf so bemessen sein sollte, daß der Betrag des zeitlichen Integrals über dieses Magnetfeld in dem Intervall dem entsprechenden Betrag für das Zeitintervall t2 bzw. t6 entspricht.

**Patentansprüche**

1. Verfahren zur Ermittlung der spektralen Verteilung der Kernmagnetisierung in einem begrenzten Volumenbereich, wobei in Anwesenheit eines stationären homogenen Magnetfeldes drei Hochfrequenzimpulse jeweils in Verbindung mit einem magnetischen Gradientenfeld auf den Untersuchungsbereich einwirken, wobei die Richtung des Gradienten des magnetischen Gradientenfeldes von Impuls zu Impuls um 90° geändert wird und das im Untersuchungsbereich erzeugte stimulierte Echosignal abgetastet und verarbeitet wird, dadurch gekennzeichnet, daß in den Intervallen zwischen den drei Hochfrequenzimpulsen und zwischen dem dritten Hochfrequenzimpuls und dem stimulierten Echosignal jeweils ein magnetisches Gradientenfeld eingeschaltet wird, daß der Gradient des im Intervall (t2) nach dem ersten Hochfrequenzimpuls und nach dem dritten Hochfrequenzimpuls erzeugten Gradientenfeldes in der gleichen Richtung verläuft und die Beziehung I1 = I3 erfüllt ist, wobei I1 bzw. I3 das zeitliche Integral über den Gradienten im Intervall (t2 bzw. t6) nach dem ersten bzw. dem dritten Hochfrequenzimpuls ist, daß der Gradient des im Intervall (t4) nach dem zweiten Hochfrequenzimpuls eingeschalteten Gradientenfeldes senkrecht zu den Gradienten der Gradientenfelder im Intervall nach dem ersten bzw. dem dritten Intervall verläuft und/oder die Beziehung I1 = I2/n erfüllt ist, wobei I2 das zeitliche Integral über den Gradienten des nach dem zweiten Hochfrequenzimpuls eingeschalteten Gradientenfeldes ist und n eine positive oder negative Zahl ist, deren Betrag von 1 und 2 abweicht, daß die Werte von I1, I2 und I3 so bemessen sind, daß alle Kernresonanzsignale bis auf das stimulierte Echosignal durch Dephasierung unterdrückt werden, und daß die Abtastwerte des stimulierten Echosignals einer Fourier-Transformationseinheit (14, 17) zugeführt werden.

2. Verfahren nach Anspruch 1, dadurch gekennzeichnet, daß die drei Hochfrequenzimpulse 90°-Hochfrequenzimpulse sind.

3. Verfahren nach Anspruch 1, dadurch gekennzeichnet, daß der Betrag von n größer oder gleich 3 ist.

4. Verfahren nach einem der Ansprüche 1 bis 3, dadurch gekennzeichnet, daß die Polarität des während des ersten bzw. dritten Hochfrequenzimpulses wirksamen magnetischen Gradientenfeldes (Gx bzw. Gz) nach dem ersten bzw. dem dritten Hochfrequenzimpuls umgeschaltet wird, daß vor dem zweiten Hochfrequenzimpuls das magnetische Gradientenfeld (Gy) mit einer zur Polarität dieses Feldes während des zweiten Hochfrequenzimpulses entgegengesetzten Polarität eingeschaltet wird, und daß der zeitliche Verlauf jedes der während eines Hochfrequenzimpulses wirksamen Gradientenfelder so gewählt ist, daß das zeitliche Integral von der Mitte des ersten bzw. des dritten Hochfrequenzimpulses bis zum Abschalten des jeweiligen Gradientenfeldes bzw. vom Einschalten des Gradientenfeldes bis zur Mitte des zweiten Hochfrequenzimpulses Null ist.

5. Anordnung zum Durchführen der Verfahrens nach Anspruch 1 mit einem Magneten zur Erzeugung eines homogenen stationären Magnetfeldes, einer Hochfrequenz-Spulenanordnung zur Erzeugung eines hochfrequenten, zum stationären Magnetfeld senkrechten Magnetfeldes, einem Hochfrequenzgenerator zur Speisung der Hochfrequenz-Spulenanordnung, einer Gradienten-Spulenanordnung zur Erzeugung von in Richtung des stationären Magnetfeldes verlaufenden Magnetfeldern mit in verschiedenen Richtungen verlaufenden Gradienten, mit Generatoren zur Speisung der Gradientenspulen, einer Steuereinheit zur Steuerung des Hochfrequenz-Generators und der Generatoren und mit einer Recheneinheit zur Verarbeitung des stimulierten Echosignals, dadurch gekennzeichnet, daß die Steuereinheit so programmiert ist, daß in den Intervallen zwischen den drei Hochfrequenzimpulsen und zwischen dem dritten Hochfrequenzimpuls und dem Auftreten des stimulierten Echosignals magnetische Gradientenfelder eingeschaltet werden, wobei der Gradient der im Intervall nach dem ersten Hochfrequenzimpuls und nach dem dritten Hochfrequenzimpuls wirksamen Gradientenfelder in der gleichen Richtung verläuft und die Beziehung I1 = I3 erfüllt ist, wobei I1 bzw. I3 das zeitliche Integral über den Gradienten im Intervall nach dem ersten bzw. dem dritten Hochfrequenzimpuls ist und wobei der Gradient des im Intervall nach dem zweiten Hochfrequenzimpuls erzeugten Gradientenfeldes senkrecht zu den Gradienten der nach dem ersten bzw. dem dritten Intervall erzeugten Gradientenfelder verläuft und/oder die Beziehung I1 = I2/n erfüllt ist, wobei I2 das zeitliche Integral über das magnetische Gradientenfeld nach dem zweiten Hochfrequenzimpuls ist und n eine positive oder negative Zahl ist, deren Betrag von 1 und 2 abweicht, und daß die Recheneinheit zum Durchführen einer Fourier-Transformation ausgebildet ist.

## Claims

1. A method of determining the spectral distribution of the nuclear magnetization in a limited volume, in which three high-frequency pulses act on the examination zone, each time in conjunction with a magnetic gradient field, in the presence of a steady, uniform magnetic field, the direction of the gradient of the magnetic gradient field being varied 90° from one pulse to another, the stimulated echo signal generated in the examination zone being sampled and processed, characterized in that each time a magnetic gradient field is activated during the intervals between the three high-frequency pulses and between the third high-frequency pulse and the stimulated echo signal, the gradient of the gradient field generated in the time interval (t2) after the first high-frequency pulse and after the third high-frequency pulse extending in the same direction and the condition I1 = I3 being satisfied, where I1 had I3 denote the time integral over the gradient in the interval after the first (t2) and after the third (t6) high-frequency pulse, respectively, the gradient of the gradient field activated during the interval (t4) after the second high-frequency pulse extending perpendicularly to the gradient of the gradient fields activated during the interval after the first and the third interval, respectively, and/or the condition I1 = I21n being satisfied, where I2 denotes the time integral over the gradient of the gradient field activated after the second high-frequency pulse and n is a positive or negative number whose absolute value deviates from 1 and 2, the values of I1, I2 and I3 being chosen so that all spin resonance signals, except for the stimulate echo signal, are suppressed by dephasing, the sampling values of the stimulated echo signal being applied to a Fourier transformation unit (14, 17).

2. A method as claimed in Claim 1, characterized in that the three high-frequency pulses are 90° high-frequency pulses.

3. A method as claimed in Claim 1, characterized in that the absolute value of n is larger than or equal to 3.

4. A method as claimed in ay one of the Claims 1 to 3, characterized in that the polarity of the magnetic gradient field (Gx, Gz) activated during the first and the third high-frequency pulse, respectively, is reversed after the first and the third high-frequency pulse, respectively, that before the second high-frequency pulse the magnetic gradient field (Gy) is activated with a polarity which opposes that of this field during the second high-frequency pulse, and that the variation in time of each gradient field activated during a high-frequency pulse is chosen so that the time integral between the centre of the first or the third high-frequency pulse and the instant of deactivation of the relevant gradient field, or between the instant of activation of the gradient field and the centre of the second high-frequency pulse, is zero.

5. A device for performing the method as claimed in Claim 1, comprising a magnet for generating a uniform, steady magnetic field, a high-frequency coil system for generating a high-frequency magnetic field which extends perpendicularly to the steady magnetic field, a high-frequency generator for feeding the high-frequency coil system, a gradient coil system for generating magnetic fields which extend in the direction of the steady magnetic field and which have gradients extending in different directions, generators for feeding the gradient coils, a control unit for controlling the high-frequency generator and the generators, and an arithmetic device for processing the stimulated echo signal, characterized in that the control unit is programmed so that magnetic gradient fields are activated during the intervals between the three high-frequency pulses as well as between the third high-frequency pulse and the instant of occurrence of the stimulated echo signal, the gradient of the gradient fields activated during the interval after the first high-frequency pulse and after the third high-frequency pulse extending in the same direction and the condition I1 = I3 being satisfied, where I1 and I3 denote the time integral over the gradient during the interval after the first and after the third high-frequency pulse, respectively, the gradient of the gradient field activated during the interval after the second high-frequency pulse extending perpendicularly to the gradients of the gradient fields activated after the first and after the third interval, respectively, and/or the condition I1 = I2/n being satisfied, where I2 is the time integral over the magnetic gradient field after the second high-frequency pulse and n is a positive or negative number whose absolute value deviates from 1 and 2, the arithmetic unit being constructed so as to perform a Fourier transformation.

**Revendications**

1. Procédé pour déterminer la distribution spectrale de la magnétisation nucléaire dans un volume limité, suivant lequel, en présence d'un champ magnétique homogène statique, trois impulsions de haute fréquence agissent sur le domaine à examiner, chacune en liaison avec un champ magnétique de gradient, et suivant lequel la direction du gradient du champ magnétique de gradient est modifiée de 90° d'impulsion à impulsion et le signal d'écho stimulé produit dans le domaine à examiner est échantillonné et traité, caractérisé en ce qu'un champ magnétique de gradient est établi dans chacun des intervalles entre les trois impulsions de haute fréquence et entre la troisième impulsion de haute fréquence et le signal d'écho stimulé; que le gradient du champ de gradient établi dans l'intervalle (t2) après la première impulsion de haute fréquence et après la troisième impulsion de haute fréquence s'étend dans la même direction et la relation I1 = I3 est satisfaite, I1 ou I3 étant l'intégrale dans le temps sur le gradient dans l'intervalle (t2 ou t6) après la première impulsion de haute fréquence ou la troisième; que le gradient du champ de gradient établi dans l'intervalle (t4) après la deuxième impulsion de haute fréquence s'étend perpendiculairement au gradient des champs de gradients dans l'intervalle après le premier intervalle ou le troisième et/ou la relation I1 = I2/n est satisfaite, où I2 est l'intégrale dans le temps sur le gradient du champ de gradient établi après la deuxième impulsion de haute fréquence et n est un nombre positif ou négatif dont la valeur est différente de 1 ou 2; que les valeurs de I1, I2 et I3 sont choisies de façon que tous les signaux de résonance magnétique nucléaire soient supprimés par déphasage jusqu'au signal d'écho stimulé, et que les valeurs d'échantillonnage du signal d'écho stimulé sont transmises à une unité de transformation de Fourier (14, 17).

2. Procédé suivant la revendication 1, caractérisé en ce que les trois impulsions de haute fréquence sont des impulsions de haute fréquence à 90°.

3. Procédé suivant la revendication 1, caractérisé en ce que la valeur de n est supérieure ou égale à 3.

4. Procédé suivant l'une quelconque des revendications 1 à 3, caractérisé en ce que la polarité du champ magnétique de gradient (Gx ou Gz) actif pendant la première impulsion de haute fréquence ou la troisième est inversée après la première impulsion de haute fréquence ou la troisième, qu'avant la deuxième impulsion de haute fréquence, le champ magnétique de gradient (Gy) est établi avec une polarité opposée à la polarité de ce champ pendant la deuxième impulsion de haute fréquence et que l'évolution dans le temps de chaque champ de gradient actif pendant une impulsion de haute fréquence est choisie de façon que l'intégrale dans le temps depuis le milieu de la première impulsion de haute fréquence ou de la troisième jusqu'à la suppression du champ de gradient afférent ou depuis l'établissement du champ de gradient jusqu'au milieu de la deuxième impulsion de haute fréquence soit nulle.

5. Dispositif pour la mise en oeuvre du procédé suivant la revendication 1, qui comprend un aimant pour produire un champ magnétique homogène statique, un montage de bobines de haute fréquence pour produire un champ magnétique de haute fréquence perpendiculaire au champ magnétique statique, un générateur de haute fréquence pour alimenter le montage de bobines de haute fréquence, un montage de bobines de gradients pour produire des champs magnétiques qui s'étendent dans la direction du champ magnétique statique avec des gradients qui s'étendent dans diverses directions, des générateurs pour alimenter les bobines de gradients, une unité de commande pour commander le générateur de haute fréquence et les générateurs et une unité de calcul pour le traitement du signal d'écho stimulé, caractérisé en ce que l'unité de commande est programmée de façon que des champs magnétiques de gradients soient établis dans les intervalles entre les trois impulsions de haute fréquence et entre la troisième impulsion de haute fréquence et l'apparition du signal d'écho stimulé, étant entendu que les gradients des champs magnétiques de gradients actifs respectivement dans l'intervalle après la première impulsion de haute fréquence et dans celui après la troisième impulsion de haute fréquence s'étendent dans la même direction et que la relation I1 = I3 est satisfaite, I1 ou I3 étant l'intégrale dans le temps sur le gradient dans l'intervalle après la première impulsion de haute fréquence ou la troisième, et que le gradient du champ de gradient établi dans l'intervalle après la deuxième impulsion de haute fréquence s'étend perpendiculairement aux gradients des champs de gradients établis après le premier intervalle et le troisième et/ou que la relation I1 = I2/n est satisfaite, I2 étant l'intégrale dans le temps sur le champ magnétique de gradient après la deuxième impulsion de haute fréquence et n étant un nombre positif ou négatif dont la valeur est différente de 1 et 2, et en ce que l'unité de calcul est conçue pour l'exécution d'une transformation de Fourier.

EP 0 233 675 B1

FIG.1

FIG.2

FIG.3

EP 0 233 675 B1